# EUROPEAN PATENT SPECIFICATION

(11) **EP 0 445 836 B1**
(45) Date of publication and mention of the grant of the patent: **06.07.1994**
(21) Application number: 91103596.2
(22) Date of filing: 08.03.1991
(51) Int. Cl.: H01L 21/82

(54) **Semiconductor device having MOS transistor and method of producing the same**
Halbleiterbauelement mit MOS Transitor und dessen Herstellungsverfahren
Dispositif à semiconducteur ayant un transistor MOS et procédé pour sa fabrication

(30) Priority: 09.03.1990 JP 58919/90
(43) Date of publication of application: 11.09.1991
(73) Proprietor: FUJITSU LIMITED, Kawasaki-shi, Kanagawa 211 (JP)
(72) Inventor: Sato, Noriaki, Machida-shi, Kanagawa 194-01 (JP)
(74) Representative: Schmidt-Evers, Jürgen, Dipl.-Ing.

(56) References cited:
- EP-A- 0 123 384
- EP-A- 0 218 408
- EP-A- 0 218 408
- EP-A- 0 218 408
- PATENT ABSTRACTS OF JAPAN vol. 6, no. 200 (E-135)(1078), 9 October 1982; & JP - A - 57107067 (FUJITSU) 03.07.1982
- idem

## Description

### BACKGROUND OF THE INVENTION

The present invention generally relates to semiconductor devices and methods of producing semiconductor devices, and more particularly to a semiconductor device having a metal oxide semiconductor (MOS) transistor provided on a substrate and a method of producing such a semiconductor device having high integration density and improved characteristics.

Recently, in order to further improve the integration density of integrated circuits (ICs), there is a demand to change a P-channel MOS transistor from a buried channel type into a surface channel type. For this reason, it is necessary to form a gate electrode from a P-type polysilicon instead of an N-type polysilicon. Ion implantation and thermal diffusion are carried out to form the gate electrode into the P-type, but there is a problem in that the P-type impurities and particularly boron (B) easily penetrate the gate electrode and reach the channel portion. The above described problem is caused by the large Rₚ of the P-type impurities such as B and the fact that the diffusion easily occurs within silicon dioxide (SiO₂), where Rₚ denotes a depth of the ion implantation from a surface.

In the preamble of the independent claims 1 and 10, the disclosure of a document JP-A-57 307 067 is referred to, since this prior art discloses the manufacture of a CMOS semiconductor device. In this document there is disclosed first to form a P-type well for the N-channel MOS transistor then to form a first gate structure, for the P-channel MOS transistor and finally a separate to form the second gate structure.

In document EP-A-0 218 408 a CMOS structure is disclosed wherein polysilicon gates are formed on a single crystal silicon substrate. The gate structure is covered by two or three layers deposited on the substrate and the gates. An anisotropic dry plasma etching process is used to remove most of the third layer. The second layer acts as an etch-stop with etching process. In the plasma etching process the portions along the sides of the gates remain to form sidewalls. By this way for a source/drain implantation process masks are built.

As one method of overcoming the above described problem, there is a known method of forming a gate insulator layer of the P-channel MOS transistor from a composite layer of SiO₂ and silicon nitride (Si₃N₄) layers in order to suppress the diffusion of the P-type impurities into the channel portion, instead of forming the gate insulator layer of the P-channel MOS transistor solely from a SiO₂ layer. The P-type impurities are much less likely to diffuse into the Si₃N₄ layer when compared to the SiO₂ layer, and the Si₃N₄ acts as a stopper with respect to the impurity diffusion.

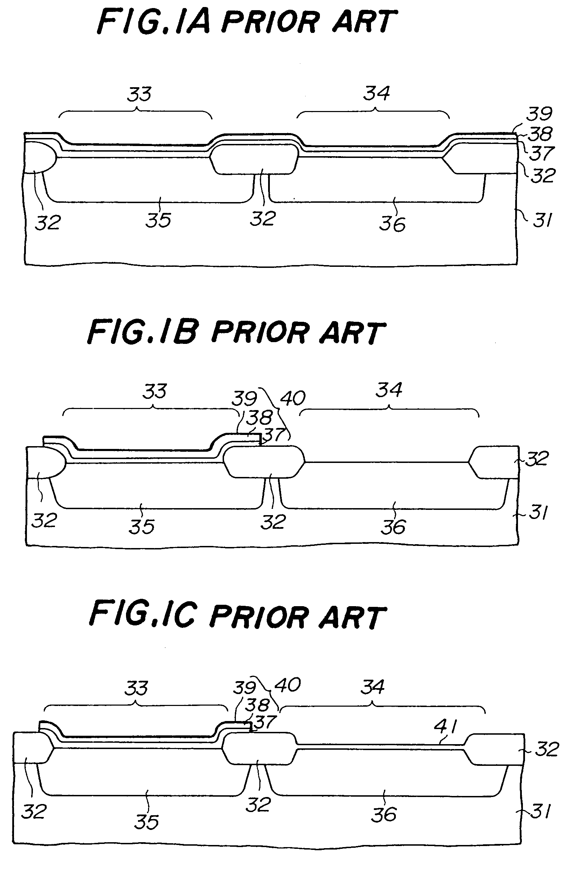

A conventional method of producing a semiconductor device will now be described with reference to FIGS.1A through 1F.

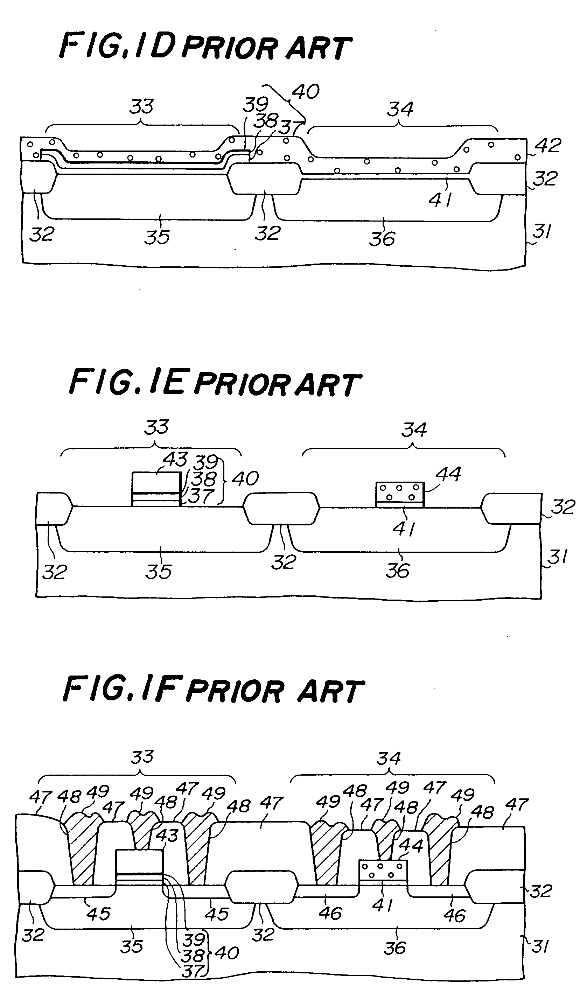

In FIG.1F, the completed semiconductor device includes a silicon (Si) substrate 31, a SiO₂ field oxide layer 32, a P-channel MOS transistor region 33 in which a P-channel MOS transistor is formed, and an N-channel MOS transistor region 34 in which an N-channel MOS transistor is formed. An N-type well 35 is formed in the P-channel MOS transistor region 33, and a P-type well 36 is formed in the N-channel MOS transistor region 34. A silicon oxide layer 37 is made of SiO₂ or the like, a silicon nitride layer 38 is made of Si₃N₄ or the like, and a silicon oxide layer 39 is made of SiO₂ or the like. A gate insulator layer 40 is made up of the silicon oxide layers 37 and 39 and the silicon nitride layer 38. A gate insulator layer 41 is made of SiO₂ or the like, and a polysilicon layer 42 is provided for forming a gate electrode. A gate electrode 43 is formed in the P-channel MOS transistor region 33, and a gate electrode 44 is formed in the N-channel MOS transistor region 34. A substrate diffusion layer 45 is formed in the P-channel MOS transistor region 33 and functions as a source/drain diffusion layer. A substrate diffusion layer 46 is formed in the N-channel MOS transistor region 34 and functions as a source/drain diffusion layer. An interlayer insulator layer 47 is made of phospho-silicate glass (PSG) or the like. A contact hole 48 is formed in the interlayer insulator layer 47, and an interconnection layer 49 is made of aluminum (Al) or the like.

The semiconductor device shown in FIG.1F is produced as follows.

First, as shown in FIG. 1A, the substrate 31 is selectively thermally oxidized by local oxidation of siliccin (LOCOS), so as to form the field oxide layer 32 as an isolation region and to form the P-channel MOS transistor region 33 and the N-channel MOS transistor region 34 as active regions. Ion implantation is used to implant N-type impurities in a region where a P-channel MOS transistor is formed and to implant P-type impurities in a region where an N-channel MOS transistor is formed, and the N-type well 35 and the P-type well 36 are formed by a thermal process. Then, the silicon oxide layer 37 which is made of SiO₂ is formed on the entire surface by a thermal oxidation, for example. Si₃N₄ is accumulated on the silicon oxide layer 37 by a chemical vapor deposition (CVD), for example, so as to form the silicon nitride layer 38. Thereafter, the silicon nitride layer 38 is oxidized by a thermal oxidation, for example, so as to form on the surface of the silicon nitride layer 38 the silicon oxide layer 39 which is made of SiO₂.

Next, as shown in FIG.1B, the silicon oxide layer 39, the silicon nitride layer 38 and the silicon oxide layer 37 of the N-channel MOS transistor region 34 are selectively etched by a reactive ion etching (RIE), for example. Hence, the gate insulator layer 40 made up of the silicon oxide layer 37, the silicon nitride layer 38 and the silicon oxide layer 39 is formed in the P-channel MOS transistor region 33 while the substrate 31 is exposed in the N-channel MOS transistor region 34.

Then, as shown in FIG.1C, the gate insulator layer 41 made of SiO₂ is formed in the N-channel MOS transistor region 34 by a thermal oxidation, for example. In this state, the silicon nitride layer 38 is further oxidized and increases the thickness of the silicon oxide layer 39.

Next, as shown in FIG.1D, a polysilicon layer 42 is accumulated to cover the entire surface of the P-channel MOS transistor region 33 and the N-channel MOS transistor region 34 by a CVD, for example. This polysilicon layer 42 is used for the gate electrode and the resistivity thereof is decreased by impurity doping.

Thereafter, as shown in FIG.1E, the polysilicon layer 42 and the gate insulator layers 40 and 41 of the respective P-channel MOS transistor region 33 and the N-channel MOS transistor region 34 are selectively etched by a RIE, for example, so as to form the gate electrode 43 in the P-channel MOS transistor region 33 and the gate electrode 44 in the N-channel MOS transistor region 34. In this state, the substrate 31 (the N-type well or the P-type well 36) is exposed in the P-channel MOS transistor region 33 and the N-type MOS transistor region 34. The gate electrode 43 of the P-channel MOS transistor region 33 and the gate electrode 44 of the N-channel MOS transistor region 34 may be formed independently. For example, the gate electrode 44 of the N-channel MOS transistor region 34 may be formed after the gate electrode 43 of the P-channel MOS transistor region 33 is formed.

In addition, it is possible to leave the silicon oxide layer 37 or the gate insulator layer 41 by etching the gate electrode using an etchant which has a high selectivity.

Next, the substrate diffusion layer 45 which becomes the source/drain diffusion layer is formed in the P-channel MOS transistor region 33, and the substrate diffusion layer 46 which becomes the source/drain diffusion layer is formed in the N-channel MOS transistor region 34. In addition, the interlayer insulator layer 47 which is made up of SiO₂ and PSG is formed on the entire surface to cover the P-channel MOS transistor region 33 and the N-channel MOS transistor region 34. The contact holes 48 are formed in the interlayer insulator layer 47 and the substrate diffusion layers 45 and 46 so as to expose the gate electrodes 43 and 44. Thereafter, the Al interconnection layer 49 is formed to make contact with the substrate diffusion layers 45 and 46 and the gate electrodes 43 and 44 via the contact holes 48. As a result, the completed semiconductor device shown in FIG. 1F is obtained.

However, according to the conventional method, there is a problem in that it is impossible to independently form the gate insulator layers 40 and 41 of the respective P-channel MOS transistor and the N-channel MOS transistor. Furthermore, there are problems in that the thicknesses of the gate insulator layers 40 and 41 cannot be controlled to desired values and it is impossible to optimize the threshold voltage Vₜₕ or the like of the MOS transistors.

The thicknesses of the gate insulator layers 40 and 41 cannot be controlled to the desired values for the following reasons. That is, when the silicon nitride layer 38 which is provided at the P-channel MOS transistor region 33 to act as a diffusion stopper is oxidized at a high temperature of 1000°C, for example, the thickness of the SiO₂ gate insulator layer 41 in the N-channel MOS transistor region 34 may become greater than the desired value. On the other hand, when an attempt is made to control the thickness of the gate insulator layer 41 in the N-channel MOS transistor region 34 to the desired value, a SiO₂ layer of a sufficient thickness cannot be formed on the silicon nitride layer 38 in the P-channel MOS transistor region 33 and the thickness of the silicon oxide layer 39 becomes less than the desired value, thereby making the withstand voltage poor. The oxidation of the silicon nitride layer 38 is carried out at the high temperature in order to stop the leak current caused by the trap of the silicon nitride layer and to prevent the initial short-circuit by mutually compensating for the pin holes existing in each layer of the multi-layer insulator layer. In addition, the oxidation of the silicon nitride layer 38 is also carried out to increase the thickness of the silicon oxide layer 39 and improve the withstand voltage, so that the deterioration caused by hot carriers is suppressed and the life time of the device as a result is prolonged.

### SUMMARY OF THE INVENTION

Accordingly, it is a general object of the present invention to provide a novel and useful semiconductor device and method of producing the semiconductor device, in which the problems described above are eliminated.

Another and more specific object of the present invention is to provide a method of producing a semiconductor device which comprises a CMOS circuit including at least an N-channel MOS transistor and a P-channel MOS transistor, comprising the steps of forming an isolation region, a P-channel MOS transistor region and an N-channel MOS transistor region in a semiconductor substrate, where the P-channel MOS transistor region has an N-type well in the semiconductor substrate and the N-channel MOS transistor region has a P-type well in the semiconductor substrate, successively forming a first insulator layer and a first conductor layer on the semiconductor substrate so as to cover the N-channel MOS transistor region, forming a first gate electrode and a first gate insulator layer of the N-channel MOS transistor on the P-type well in the N-channel MOS transistor region by selectively etching the first conductor layer and the first insulator layer, successively forming a second insulator layer and a second conductor layer on the semiconductor substrate so as to cover at least the P-channel MOS transistor region, and forming a second gate electrode and a second gate insulator layer of the P-channel MOS transistor on the N-type well in the P-channel MOS transistor region by selectively etching the second conductor layer and the second insulator layer. According to the method of the present invention, it is possible to form the gate insulator layers of the P-channel and N-channel MOS transistors to the desired thicknesses. Hence, the threshold voltage and the like of the transistors can be optimized and the transistor characteristics are improved.

Still another object of the present invention is to provide a semiconductor device comprising a semiconductor substrate, a P-type well formed in the semiconductor substrate, a gate insulator layer formed on the semiconductor substrate, N-type diffusion regions formed in the P-type well on both sides of the gate insulator layer, a gate electrode formed on the gate insulator layer, where the gate electrode has top and side surfaces and the gate electrode and the N-type diffusion regions respectively form gate, source and drain of an N-channel MOS transistor, an insulating layer which covers a portion of the N-type diffusion regions, the side surfaces of the gate electrode and at least a portion of the top surface of the gate electrode, and a sidewall layer which is made of an insulating material and is formed on the insulating layer to provide a smooth coverage around the side of the gate electrode. According to the semiconductor device of the present invention, it is possible to protect the gate electrode of the N-channel MOS transistor by the provision of the insulating layer.

A further object of the present invention is to provide a semiconductor device having a CMOS circuit which includes at least a P-channel MOS transistor and an N-channel MOS transistor. The semiconductor device comprises a semiconductor substrate, and a P-channel MOS transistor region and an N-channel MOS transistor region isolated by an isolation region formed on the semiconductor substrate. The P-channel MOS transistor region comprises an N-type well formed in the semiconductor substrate, a first gate insulator layer formed on the semiconductor substrate, P-type diffusion regions formed in the N-type well on both sides of the first gate insulator layer, and a first gate electrode formed on the first gate insulator layer, where the first gate electrode and the P-type diffusion regions respectively form gate, source and drain of the P-channel MOS transistor. The N-channel MOS transistor region comprises a P-type well formed in the semiconductor substrate, a second gate insulator layer formed on the semiconductor substrate, N-type diffusion regions formed in the P-type well on both sides of the second gate insulator layer, a second gate electrode formed on the second gate insulator layer, where the second gate electrode has top and side surfaces and the second gate electrode and the N-type diffusion regions respectively form gate, source and drain of the N-channel MOS transistor, an insulating layer which covers a portion of the N-type diffusion regions, the side surfaces of the gate electrode and at least a portion of the top surface of the gate electrode, where the insulating layer is made of the same material as the first gate insulator, and a sidewall layer which is made of the same material as the first gate electrode and is formed on the insulating layer to provide a smooth coverage around the side of the second gate electrode.

Other objects and further features of the present invention will be apparent from the following detailed description when read in conjunction with the accompanying drawings.

### BRIEF DESCRIPTION OF THE DRAWINGS

FIGS.1A through 1F are cross sectional views for explaining an example of a conventional method of producing a semiconductor device;
FIGS.2A through 2J are cross sectional views for explaining an embodiment of a method of producing a semiconductor device according to the present invention;

### DESCRIPTION OF THE PREFERRED EMBODIMENTS

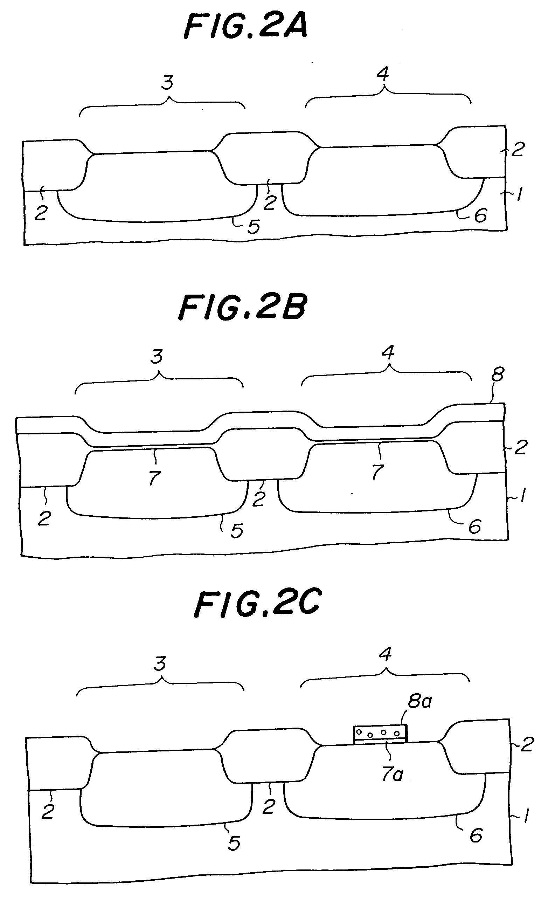

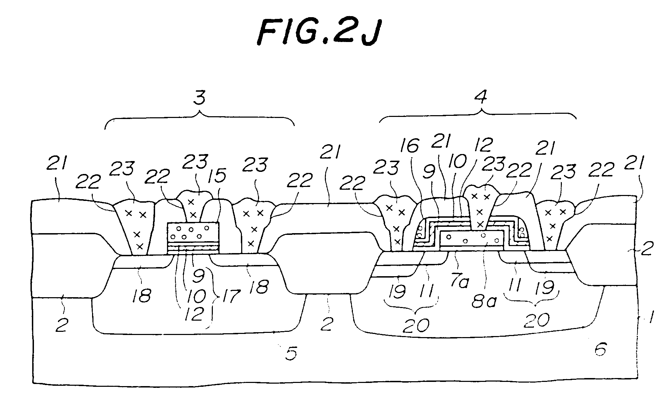

An embodiment of a method of producing a semiconductor device according to the present invention will be described with reference to FIGS.2A through 2J. This embodiment of the method produces an embodiment of a semiconductor device according to the present invention shown in FIG.2J.

The embodiment of the semiconductor device shown in FIG.2J includes a semiconductor substrate 1 made of Si or the like, a field oxide layer 2 made of SiO₂ or the like, a P-channel MOS transistor region 3, an N-channel MOS transistor region 4, an N-type well 5, and a P-type well 6.

A first insulator layer 7 for forming the gate insulator layer of the N-channel MOS transistor is made of SiO₂ or the like, and a first gate insulator layer 7a of the N-channel MOS transistor is made of SiO₂ or the like. A first conductor layer 8 for forming the gate electrode of the N-channel MOS transistor is made of polysilicon or the like, and a first gate electrode 8a of the N-channel MOS transistor is made of polysilicon or the like.

A silicon oxide layer 9 for forming the gate insulator layer of the P-channel MOS transistor is made of SiO₂ or the like. A silicon nitride layer 10 for forming the gate insulator layer of the P-channel MOS transistor is made of Si₃N₄ or the like. A low impurity density diffusion layer 11 is an n⁻-type layer, for example, and a silicon oxide layer 12 for forming the gate insulator layer of the P-channel MOS transistor is made of SiO₂ or the like. A second insulator layer 13 is made up of the silicon oxide layer 9, the silicon nitride layer 10 and the silicon oxide layer 12. A second conductor layer 14 for forming the gate electrode of the P-channel MOS transistor is made of polysilicon or the like. A second gate electrode 15 of the P-channel MOS transistor is made of polysilicon or the like. A side wall layer 16 is made of polysilicon or the like. A second gate insulator layer 17 is made up of the silicon oxide layer 9, the silicon nitride layer 10 and the silicon oxide layer 12. A p⁺-type substrate diffusion layer 18 acts as a source/drain diffusion layer of the P-channel MOS transistor. A high impurity density diffusion layer 19 is an n⁺-type layer, for example. A substrate diffusion layer 20 acts as the diffusion layers 11 and 19 which act as the source/drain of the N-channel MOS transistor. An interlayer insulator layer 21 is made of PSG or the like. Contact holes 22 are formed in the interlayer insulator layer 21, and an interconnection layer 23 is made of Al or the like.

First, as shown in FIG.2A, a silicon nitride layer to be subjected to the LOCOS is formed, and thereafter, the N-type well 5 and the P-type well 6 are formed in the respective P-channel MOS transistor region 3 and the N-channel MOS transistor region 4. Then, the substrate 1 is selectively subjected to a thermal oxidation by LOCOS. As a result, the field oxide layer 2 of 500 nm, for example, is formed as the isolation region, and the P-channel MOS transistor region 3 and the N-channel MOS transistor region 4 are formed as active regions.

Next, as shown in FIG.2B, the substrate 1 is oxidized at the P-channel MOS transistor region 3 and the N-channel MOS transistor region 4 by a thermal oxidation, for example, so as to form the first insulator layer 7. The insulator layer 7 forming the gate insulator layer of the N-channel MOS transistor has a thickness of 10 nm, for example, and is formed on the substrate 1 so as to cover the N-channel MOS transistor region 4. Thereafter, a polysilicon is accumulated on the first insulator layer 7 by a CVD, for example, so as to form the first conductor layer 8. This first conductor layer 8 for forming the gate electrode of the N-channel MOS transistor has a thickness of 250 nm, for example.

Then, as shown in FIG.2C, the first conductor layer 8 and the first insulator layer 7 are selectively etched by a RIE, for example, so as to form the first gate electrode 8a and the first gate insulator layer 7a in the N-channel MOS transistor region 4.

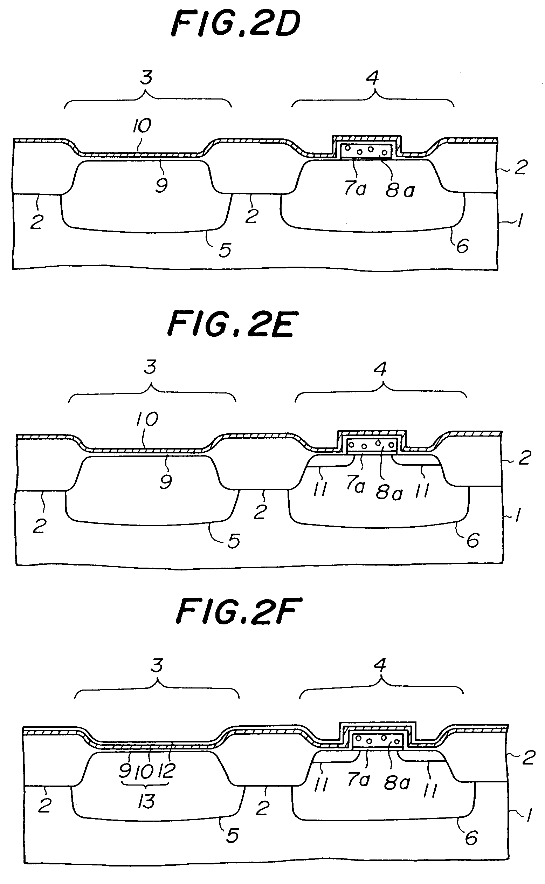

Next, as shown in FIG.2D, the silicon oxide layer 9 is formed by a thermal oxidation, for example. The silicon oxide layer 9 for forming the gate insulator layer of the P-channel MOS transistor has a thickness of 5 nm, for example. A Si₃N₄ layer is accumulated on the silicon oxide layer 9 by a CVD, for example, so as to form the silicon nitride layer 10 which has a thickness of 9 nm, for example.

Thereafter, as shown in FIG.2E, P-type impurities such as As are implanted into the substrate 1 at only the N-channel MOS transistor region 4, so as to form the n⁻-type diffusion layer 11. For example, an ion implantation using a resist mask is employed to implant the P-type impurities into the substrate 1.

Next, as shown in FIG.2F, the silicon nitride layer 10 is selectively oxidized by a thermal oxidation, so as to form the silicon oxide layer 12 which is made of SiO₂ and has a thickness of 5 nm, for example. The silicon oxide layer 12 is formed by the oxidation of the surface portion of the silicon nitride layer 10. Hence, the second insulator layer 13 which is made up of the silicon oxide layer 9, the silicon nitride layer 10 and the silicon oxide layer 12 is formed to cover the P-channel MOS transistor region 3.

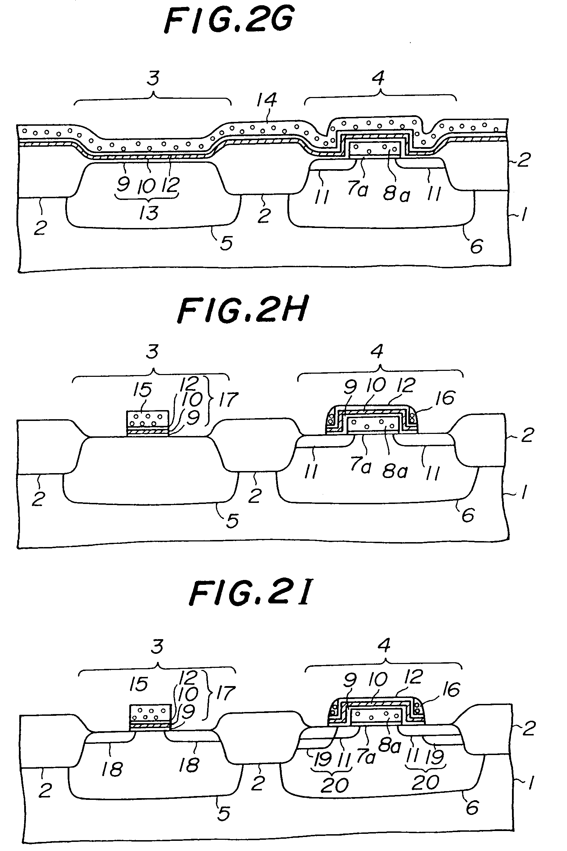

Then, as shown in FIG.2G, a polysilicon is accumulated on the second insulator layer 13 by a CVD, for example, so as to form the second conductor layer 14. For example, the second conductor layer 14 has a thickness of 250 nm.

Next, as shown in FIG.2H, the second conductor layer 14 is selectively etched by a RIE, for example, so as to form the second gate electrode 15 in the P-channel MOS transistor region 3 and the sidewall layer 16 on the sidewall of the first gate electrode 8a. Thereafter, the second insulator layer which is made up of the silicon oxide layer 12, the silicon nitride layer 10 and the silicon oxide layer 9 is selectively etched by a RIE, for example, so as to form the second gate insulator layer 17 in the P-channel MOS transistor region 3. This second gate insulator layer 17 is made up of the silicon oxide layer 12, the silicon nitride layer 10 and the silicon oxide layer 9. In this state, the substrate 1 is exposed at the P-channel MOS transistor region 3 and the N-channel MOS transistor region 4.

Then, as shown in FIG.2(I), the P⁺-type substrate diffusion layer 18 which becomes the source/drain is formed in the P-channel MOS transistor region 3, and the N⁺-type diffusion layer 19 is formed in the N-channel MOS transistor region 4 so as to form the substrate diffusion layer 20 which is made up of the diffusion layers 11 and 19 and becomes the source/drain.

The interlayer insulator layer 21 made up of SiO₂ and PSG is formed thereafter, and the contact holes 22 are formed in the interlayer insulator layer 21 so that the substrate diffusion layers 18 and 20 and the first and second gate electrodes 8a and 15 are exposed. The interconnection layer 23 made of Al is formed so that contact is made to the substrate diffusion layers 18 and 20 and the first and second gate electrodes 8a and 15 via the contact holes 22. As a result, the semiconductor device shown in FIG.2J is completed. Normally, the silicon nitride layer 10 extends to and is connected to a portion of another element which is formed on the substrate 1. That is, the silicon nitride layer 10 is made from the same layer which forms a portion of another element on the same substrate 1. In addition, the silicon nitride layer 10 of the N-channel MOS transistor may connect to the silicon nitride layer 10 (or 17) of the P-channel MOS transistor at a part of the semiconductor device.

Therefore, in this embodiment, the first gate insulator layer 7a of the N-channel MOS transistor is formed before the second gate insulator layer 17 of the P-channel MOS transistor is formed. In other words, the first gate insulator layer 7a of the N-channel MOS transistor and the second gate insulator layer 17 of the P-channel MOS transistor are formed by independent processes. For this reason, the first and second gate insulator layers 7a and 17 can respectively be formed to the desired values, and the threshold voltage Vₜₕ and the like of the two transistors can be optimized.

In addition, because the silicon nitride layer 10 is formed on the sidewall of the first gate electrode 8a in the N-channel MOS transistor region 4 so as to act as an insulator layer, it is possible to improve the withstand voltage between the first gate electrode 8a and the interconnection layer 23. Furthermore, since the silicon oxide layer 9, the silicon nitride layer 10 and the silicon oxide layer 12 are formed on the sidewall of the first gate electrode 8a, it is possible to suppress deterioration caused by hot carriers and accordingly improve the reliability of the transistors and life time of the device.

In the described embodiment, the interlayer insulator layer 21 is formed so as to cover the sidewall layer 16 in a state where the sidewall layer 16 is left as shown in FIG.2I.

In a best mode of the present invention, the anisotropic etching in FIG.2C and/or 2H is carried out using different etchant gasses for etching the polysilicon layer and the oxide layer. In other words, in FIG.2C, for example, the polysilicon layer 8 is etched by an anisotropic etching using a first etchant gas to form the first gate electrode 8a and this etching is stopped at the first insulator layer 7. Then, an anisotropic etching using a second etchant gas which is different from the first etchant gas is carried out to etch the first insulator layer 7 to form the first gate insulator layer 7a. The anisotropic etching using different etchant gasses may be carried out similarly to form the second gate electrode 15 in FIG.2H.

In the above embodiment, the N-channel MOS transistor is described as having the LDD structure. However, the present invention is not limited to such, and may similarly be applied to the P-channel MOS transistor and the normal source/drain diffusion layer structure. Furthermore, the first and second gate electrodes 8a and 15 may respectively be made of a material other than polysilicon, such as silicide and polycide.

The second insulator layer 13 may be made of a silicon nitride such as Si₃N₄ or a silicon nitride oxide such as SiON. Moreover, a multi-layer structure may be used as the second insulator layer 13, and the multi-layer structure may be SiO₂/Si₃N₄/SiO₂, SiON/SiO₂, SiO₂Si₃N₄, SiO₂/Si₃N₄, SiO₂/SiON, Si₃N₄/SiO₂ or the like.

The structures of the semiconductor devices shown in FIGS.2J and 3 bring out the following advantageous features. That is, because the silicon nitride layer 11 covers a top portion of the first gate electrode 8a, it is possible to prevent chemicals and the like from being absorbed by the first gate electrode 8a at a stage after the formation of the first gate electrode 8a, especially when the first gate electrode 8a is made of polysilicon. In addition, the provision of the silicon nitride layer 11 protects the top portion of the first gate electrode 8a from oxidation at a stage after the formation of the first gate electrode 8a. Therefore, the silicon nitride layer 11 acts as a protection layer for protecting the first gate electrode 8a, and it is possible to prevent the characteristics of the semiconductor device (MOS transistors) from becoming deteriorated.

## Claims

1. A method of producing a semiconductor device which comprises a CMOS circuit including at least an N-channel MOS transistor and a P-channel MOS transistor, said method comprising the step of forming an isolation region (2), a P-channel MOS transistor region (3) and an N-channel MOS transistor region (4) in a semiconductor substrate (1), said P-channel MOS transistor region having an N-type well (5) in the semiconductor substrate, said N-channel MOS transistor region having a P-type well (6) in the semiconductor substrate, there are provided the steps of: successively forming a first insulator layer (7) and a first conductor layer (8) on the semiconductor substrate (1) so as to cover the N-channel MOS transistor region (4);
characterized by forming a first gate electrode (8a) and a first gate insulator layer (7a) of the N-channel MOS transistor on the P-type well (6) in the N-channel MOS transistor region by selectively etching the first conductor layer (8) and the first insulator layer (7); successively forming a second insulator layer (13) and a second conductor layer (14) on the semiconductor substrate so as to cover at least the P-channel MOS transistor region (3); and
forming a second gate electrode (15) and a second gate insulator layer (17) of the P-channel MOS transistor on the N-type well (5) in the P-channel MOS transistor region by selectively etching the second conductor layer and the second insulator layer; said step of forming the second insulator layer (13) and the second conductor layer (14) also forms the second insulator layer and the second conductor layer over the first gate electrode (8a) and the first gate insulator layer (7a), and said step of forming the second gate electrode (15) and the second gate insulator layer (17) forms a sidewall layer (16) at a sidewall of the first gate electrode when selectively etching the second conductor layer to form the second gate electrode.

2. The method of producing the semiconductor device as claimed in claim 1, characterized in that said step of forming the second gate electrode (15) and the second gate insulator layer (17) selectively etches the second conductor layer (14) by an anisotropic etching.

3. The method of producing the semiconductor device as claimed in claim 1 or 2, characterized in that there is further provided a step of removing the sidewall layer (16).

4. The method of producing the semiconductor device as claimed in claim 1 characterized in that there are further provided the steps of: forming P-type diffusion regions (18) in the N-type well (5) on both sides of the second gate electrode (15) as source and drain of the P-channel MOS transistor and N-type diffusion regions (20) in the P-type well (6) on both sides of the first gate electrode (8a) as source and drain of the N-channel MOS transistor; forming an interlayer insulator layer (21) over the N-channel MOS transistor region (4) and the P-channel MOS transistor region (3); forming contact holes (22) in the interlayer insulator layer so that one contact hole exposes a surface of the first gate electrode and another contact holes exposes a surface of the second gate electrode; and forming an interconnection layer (23) on the interlayer insulator layer for making contact to the first and second gate electrodes via the respective contact holes.

5. The method of producing the semiconductor device as claimed in any of claims 1 to 4, characterized in that said step of forming the first gate electrode (8a) and the first gate insulator layer (7a) carries out an anisotropic etching to etch the first conductor layer (8) and the first insulator layer (7) using mutually different etchant gasses.

6. The method of producing the semiconductor device as claimed in any of claims 1 to 5, characterized in that said step of forming the second gate electrode (15) and the second gate insulator layer (17) carries out an anisotropic etching to etch the second conductor layer (14) and the second insulator layer (13) using mutually different etchant gasses.

7. The method of producing the semiconductor device as claimed in any of claims 1 to 6, characterized in that the first and second conductor layers (8, 14) are respectively made of a material selected from a group consisting of polysilicon, silicide and polycide.

8. The method of producing the semiconductor device as claimed in any of claims 1 to 7, characterized in that the second insulator layer (13) is made of a material selected from a group consisting of Si₃N₄ and SiON.

9. The method of producing the semiconductor device as claimed in any of claims 1 to 7, characterized in that the second insulator layer (13) has a multi-layer structure selected from a group consisting of
SiO₂/Si₃N₄/SiO₂, SiON/SiO₂,
SiO₂Si₃N₄, SiO₂/Si₃N₄, SiO₂/SiON and
Si₃N₄ /SiO₂.

10. A semiconductor device having a CMOS circuit which includes at least a P-channel MOS transistor and an N-channel MOS transistor, said semiconductor device comprising a semiconductor substrate (1); and a P-channel MOS transistor region (3) and an N-channel MOS transistor region (4) isolated by an isolation region (2) formed on the semiconductor substrate,
said P-channel MOS transistor region comprising:
an N-type well (5) formed in the semiconductor substrate (1); a second gate insulator layer (17) formed on the semiconductor substrate;
P-type diffusion regions (18) formed in the N-type well on both sides of the second gate insulator layer; and a second gate electrode (15) formed on the second gate insulator layer, said second gate electrode and said P-type diffusion regions respectively forming gate, source and drain of the P-channel MOS transistor, said N-channel MOS transistor region comprising:
a P-type well (6) formed in the semiconductor substrate; a first gate insulator layer (7a) formed on the semiconductor substrate;
N-type diffusion regions (20) formed in the P-type well on both sides of the first gate insulator layer; and a first gate electrode (8a) formed on the first gate insulator layer, said first gate electrode having top and side surfaces, said first gate electrode and said N-type diffusion regions respectively forming gate, source and drain of the N-channel MOS transistor,
characterized in that said N-channel MOS transistor region is provided with: an insulating layer (9, 10, 12) which covers a portion of the N-type diffusion regions (20), the side surfaces of the first gate (7a, 8a) and at least a portion of the top surface of the first gate electrode (8a), said insulating layer being identical with said second gate insulator (17); and a sidewall layer (16) which is made of the same material as said second gate electrode (15), being formed on the insulating layer (9,10,12) to provide a smooth coverage around the side of the first gate electrode and forming in combination with the insulating layer (9, 10, 12) the sidewall of the first gate (7a, 8a).

11. The semiconductor device as claimed in claim 10, characterized in that the first and second gate electrodes (8a, 15) are respectively made of a material selected from a group consisting of polysilicon, silicide and polycide.

12. The semiconductor device as claimed in claim 10 or 11, characterized in that the insulating layer (10) is made of a material selected from a group consisting of Si₃N₄ and SiON.

13. The semiconductor device as claimed in claim 10 or 11, characterized in that the insulating layer (10) has a multi-layer structure selected from a group consisting of
SiO₂/Si₃N₄/SiO₂,
SiON/SiO₂, SiO₂Si₃N₄, SiO₂ /Si₃N₄,
SiO₂/SiON and Si₃N₄/SiO₂.

14. The semiconductor device as claimed in any of claims 10 to 13, which further comprises another element which is formed on the semiconductor substrate (1), and said insulating layer (10) extends to connect to and form a portion of the element.

15. The semiconductor device as claimed in any of claims 10 to 14, characterized in that said insulating layer (9, 10, 12) is connected to said second gate insulator (17) at a part of the semiconductor device.

## Patentansprüche

1. Verfahren zum Herstellen eines Halbleiterbauelementes, das einen CMOS- Schaltkreis aufweist, der zumindest einen N-Kanal-MOS-Transistor und einen P-Kanal-MOS-Transistor aufweist, wobei das Verfahren die Schritte umfaßt, einen Isolationsbereich (2), einen P-Kanal-MOS-Transistorbereich (3) und einen N-Kanal-MOS-Transistorbereich (4) in einem Halbleitersubstrat (1) auszubilden, wobei der P-Kanal-MOS-Transistorbereich eine N-Wanne (5) in dem Halbleitersubstrat aufweist, der N-Kanal-MOS-Transistorbereich eine P-Wanne (6) in dem Halbleitersubstrat aufweist, wobei die Schritte vorgesehen sind: nacheinanderfolgend eine erste Isolationsschicht (7) und eine erste Leiterschicht (8) auf dem Halbleitersubstrat (1) auszubilden, so daß der N-Kanal-MOS-Transistorbereich (4) abgedeckt ist;
**dadurch gekennzeichnet,**
daß mittels selektivem Ätzen der ersten Leiterschicht (8) und der ersten Isolationsschicht (7) eine erste Gate-Elektrode (8a) und eine erste Gate-Isolationsschicht (7a) des N-Kanal-MOS-Transistors in der P-Wanne (6) im N-Kanal-MOS-Transistorbereich ausgebildet werden,
daß nacheinanderfolgend eine zweite Isolationsschicht (13) und eine zweite Leiterschicht (14) auf dem Halbleitersubstrat ausgebildet werden, so daß zumindest der P-Kanal-MOS-Transistorbereich (3) abgedeckt ist; und
daß mittels selektivem Ätzen der zweiten Leiterschicht und der zweiten Isolationsschicht eine zweite Gate-Elektrode (15) und eine zweite Gate-Isolationsschicht (17) des P-Kanal-MOS-Transistors in der N-Wanne (5) im P-Kanal-MOS-Transistorbereich ausgebildet werden, wobei der Schritt des Ausbildens der zweiten Isolationsschicht (13) und der zweiten Leiterschicht (14) auch die zweite Isolationsschicht und die zweite Leiterschicht über der ersten Gate-Elektrode (8a) und der ersten Gate-Isolationsschicht (7a) ausbildet und wobei der Schritt des Ausbildens der zweiten Gate-Elektrode (15) und der zweiten Gate-Isolationsschicht (17) eine Seitenwand-Schicht (16) an einer Seitenwand der ersten Gate-Elektrode ausbildet, wenn die zweite Leiterschicht zum Ausbilden der zweiten Gate-Elektrode selektiv geätzt wird.

2. Verfahren zum Herstellen des Halbleiterbauelementes nach Anspruch 1,
**dadurch gekennzeichnet,**
daß der Schritt des Ausbildens der zweiten Gate-Elektrode (15) und der zweiten Gate-Isolationsschicht (17) die zweite Leiterschicht (14) mittels eines anisotropischen Ätzens selektiv ätzt.

3. Verfahren zum Herstellen des Halbleiterbauelementes nach Anspruch 1 oder 2,
**dadurch gekennzeichnet,**
daß weiterhin der Schritt vorgesehen ist, die Seitenwandschicht (16) zu entfernen.

4. Verfahren zum Herstellen des Halbleiterbauelementes nach Anspruch 1,
**dadurch gekennzeichnet,**
daß weiterhin die Schritte vorgesehen sind: Ausbilden von P-Diffusionsbereichen (18) in der N-Wanne (5) auf beiden Seiten der zweiten Gate-Elektrode (15) als Source und Drain des P-Kanal-MOS-Transistors und von N-Diffusionsbereichen (20) in der P-Wanne (6) auf beiden Seiten der Gate-Elektrode (8a) als Source und Drain des N-Kanal-MOS-Transistors, Ausbilden einer Zwischenschicht-Isolationsschicht (21) über dem N-Kanal-MOS-Transistorbereich (4) und dem P-Kanal-MOS-Transistorbereichs (3); Ausbilden von Kontaktlöchern (22) in der Zwischenschicht-Isolationsschicht, so daß ein Kontaktloch eine Oberfläche der ersten Gate-Elektrode freilegt, und ein anderes Kontaktloch eine Oberfläche der zweiten Gate-Elektrode freilegt; und Ausbilden einer Zwischenverbindungsschicht (23) auf der Zwischenschicht-Isolationsschicht, um einen Kontakt zur ersten und zweiten Gate-Elektrode über die jeweiligen Kontaktlöcher herzustellen.

5. Verfahren zum Herstellen des Halbleiterbauelementes nach einem der Ansprüche 1 bis 4,
**dadurch gekennzeichnet,**
daß der Schritt des Ausbildens der ersten Gate-Elektrode (8a) und der ersten Gate-Isolationsschicht (7a) ein anisotropisches Ätzen ausführt, um unter Verwendung als wechselnd verschiedener Ätzgase die erste Leiterschicht (8) und die erste Isolationsschicht (7) zu ätzen.

6. Verfahren zum Herstellen des Halbleiterbauelementes nach einem der Ansprüche 1 bis 5,
**dadurch gekennzeichnet,**
daß der Schritt des Ausbildens der zweiten Gate-Elektrode (15) und der zweiten Gate-Isolationsschicht (17) ein anisotropisches Ätzen ausführt, um unter Verwendung als wechselnd verschiedener Ätzgase die zweite Leiterschicht (14) und die zweite Isolationsschicht (13) zu ätzen.

7. Verfahren zum Herstellen des Halbleiterbauelementes nach einem der Ansprüche 1 bis 6,
**dadurch gekennzeichnet,**
daß die erste und die zweite Isolationsschicht (8, 14) jeweils aus einem Material hergestellt ist, das aus der Gruppe ausgewählt ist, die aus Polysilizium, Silicid und Polycid besteht.

8. Verfahren zum Herstellen des Halbleiterbauelementes nach einem der Ansprüche 1 bis 7,
**dadurch gekennzeichnet,**
daß die zweite Isolationsschicht (13) aus einem Material hergestellt ist, das aus der Gruppe ausgewählt ist, die aus Si₃N₄ und SiON besteht.

9. Verfahren zum Herstellen des Halbleiterbauelementes nach einem der Ansprüche 1 bis 7,
**dadurch gekennzeichnet,**
daß die zweite Isolationsschicht (13) eine Mehrschicht-Struktur aufweist, die aus einer Gruppe ausgewählt ist, die aus
SiO₂/Si₃N₄/SiO₂, SiON/SiO₂,
SiO₂Si₃N₄, SiO₂/Si₃N₄, SiO₂/SiON und
Si₃N₄/SiO₂ besteht.

10. Halbleiterbauelement mit einer CMOS-Schaltung, die zumindest einen P-Kanal-MOS-Transistor und einen N-Kanal-MOS-Transistor enthält, wobei das Halbleiterbauelement ein Halbleitersubstrat (1) aufweist; wobei ein P-Kanal-MOS-Transistorbereich (3) und ein N-Kanal-MOS-Transistor-Bereich (4), die mittels eines Isolationsbereiches (2) isoliert sind, auf dem Halbleitersubstrat ausgebildet sind,
wobei der P-Kanal-MOS-Transistor-Bereich eine N-Wanne (5), die in dem Halbleitersubstrat (1) ausgebildet ist, eine zweite Gate-Isolationsschicht (17), die auf dem Halbleitersubstrat ausgebildet ist,
P-Diffusionsbereiche (18), die in der N-Wanne auf beiden Seiten der zweiten Gate-Isolationsschicht ausgebildet sind, und eine zweite Gate-Elektrode (15) aufweist, die auf der zweiten Gate-Isolationsschicht ausgebildet ist, wobei die zweite Gate-Elektrode und die P-Diffusionsbereiche jeweils Gate, Source und Drain des P-Kanal-MOS-Transitors bilden, wobei der N-Kanal-MOS-Transistorbereich eine P-Wanne (6), die in dem Halbleitersubstrat ausgebildet ist, eine erste Gate-Isolationsschicht (7a), die auf dem Halbleitersubstrat ausgebildet ist,
N-Diffusionsbereiche (20), die in der P-Wanne auf beiden Seiten der Gate-Isolationsschicht ausgebildet sind, und eine erste Gate-Elektrode (8a) aufweist, die auf der ersten Gate-Isolationsschicht ausgebildet ist, wobei die erste Gate-Elektrode Ober- und Seiten-Oberflächen aufweist, wobei die erste Gate-Elektrode und die N-Diffusionsbereiche jeweils Gate, Source und Drain des N-Kanal-MOS-Transistors bilden,
**dadurch gekennzeichnet,**
daß der N-Kanal-MOS-Transistorbereich eine Isolationsschicht (9, 10, 12), die einen Teil des N-Diffusionsbereichs (20), die Seiten-Oberflächen des Gates (7a, 8a) und zumindest einen Teil der Ober-Oberfläche der ersten Gate-Elektrode (8a) abdeckt, wobei die Isolationsschicht mit der zweiten Gate-Isolationsschicht (17) identisch ist, und eine Seitenwand-Schicht (16) aufweist, die aus demselben Material wie die zweite Gate-Elektrode (15) hergestellt ist, die auf der Isolationsschicht (9, 10, 12) ausgebildet ist, um eine leichte Abdeckung um die Seiten der ersten Gate-Elektrode vorzusehen und um in Kombination mit der Isolationsschicht (9, 10, 12) die Seitenwand des ersten Gates (7a, 8a) auszubilden.

11. Halbleiterbauelement nach Anspruch 10,
**dadurch gekennzeichnet,**
daß die erste und die zweite Gate-Elektrode (8a, 15) jeweils aus einem Material hergestellt sind, das aus der Gruppe ausgewählt ist, die aus Polysilizium, Silicid und Polycid besteht.

12. Halbleiterbauelement nach Anspruch 10 oder 11,
**dadurch gekennzeichnet,**
daß die Isolationsschicht (10) aus einem Material hergestellt ist, das aus einer Gruppe ausgewählt ist, die aus Si₃N₄ und SiON besteht.

13. Halbleiterbauelement nach Anspruch 10 oder 11,
**dadurch gekennzeichnet,**
daß die Isolationschicht (10) eine Mehrschicht-Struktur aufweist, die aus einer Gruppe ausgewählt ist, die aus
SiO₂/Si₃N₄/SiO₂,
SiON/SiO₂, SiO₂Si₃N₄, SiO₂/Si₃N₄,
SiO₂/SiON und Si₃N₄/SiO₂ besteht.

14. Halbleiterbauelement nach einem der Ansprüche 10 bis 13,
wobei weiterhin ein weiteres Element vorgesehen ist, das auf dem Halbleitersubstrat (1) ausgebildet ist, und wobei die Isolationsschicht (10) sich so erstreckt, daß sie einen Teil des Elementes anschließt und ausbildet.

15. Halbleiterbauelement nach einem der Ansprüche 10 bis 14,
**dadurch gekennzeichnet,**
daß die Isolationsschicht (9, 10, 12) mit dem zweiten Gate-Isolator (17) an einem Teil des Halbleiterbauelementes angeschlossen ist.

## Revendications

1. Procédé de production d'un dispositif à semiconducteur qui comprend un circuit CMOS comportant au moins un transistor MOS à canal N et un transistor MOS à canal P, ledit procédé comprenant l'opération qui consiste à former une région d'isolation (2), une région (3) de transistor MOS à canal P et une région (4) de transistor MOS à canal N dans un substrat semiconducteur (1), ladite région de transistor MOS à canal P comportant un puits de type N (5) dans le substrat semiconducteur, ladite région de transistor MOS à canal N comportant un puits de type P (6) dans le substrat semiconducteur, étant prévues les opérations consistant à former successivement une première couche d'isolant (7) et une première couche de conducteur (8) sur le substrat semiconducteur (1) de façon à couvrir la région (4) de transistor MOS à canal N ;
caractérisé en ce qu'on forme une première électrode de grille (8a) et une première couche d'isolant de grille (7a) du transistor MOS à canal N sur le puits de type P (6) dans la région de transistor MOS à canal N par gravure sélective de la première couche de conducteur (8) et de la première couche d'isolant (7) ;
on forme successivement une deuxième couche d'isolant (13) et une deuxième couche de conducteur (14) sur le substrat semiconducteur de façon à couvrir au moins la région (3) de transistor MOS à canal P ; et
on forme une deuxième électrode de grille (15) et une deuxième couche d'isolant de grille (17) du transistor MOS à canal P sur le puits de type N (5) dans la région de transistor MOS à canal P par gravure sélective de la deuxième couche de conducteur et de la deuxième couche d'isolant ; ladite opération de formation de la deuxième couche d'isolant (13) et de la deuxième couche de conducteur (14) formant également la deuxième couche d'isolant et la deuxième couche de conducteur par-dessus la première électrode de grille (8a) et la première couche d'isolant de grille (7a), et ladite opération de formation de la deuxième électrode de grille (15) et de la deuxième couche d'isolant de grille (17) formant une couche de paroi latérale (16) au niveau d'une paroi latérale de la première électrode de grille lors de la gravure sélective de la deuxième couche de conducteur visant à former la deuxième électrode de grille.

2. Procédé de production d'un dispositif à semiconducteur selon la revendication 1, caractérisé en ce que ladite opération de formation de la deuxième électrode de grille (15) et de la deuxième couche d'isolant de grille (17) grave sélectivement la deuxième couche de conducteur (14) par une gravure anisotrope.

3. Procédé de production d'un dispositif à semiconducteur selon la revendication 1 ou 2, caractérisé en ce qu'il est en outre prévu une opération consistant à retirer la couche de paroi latérale (16).

4. Procédé de production d'un dispositif à semiconducteur selon la revendication 1, caractérisé en ce que sont en outre prévues les opérations suivantes : former des régions (18) de diffusion de type P dans le puits de type N (5) de part et d'autre de la deuxième électrode de grille (15) au titre de source et de drain du transistor MOS à canal P, et des régions (20) de diffusion de type N dans le puits de type P (6) part et d'autre de la première électrode de grille (8a) au titre de source et de drain du transistor MOS à canal N ; former une couche d'isolant intercouche (21) par-dessus la région (4) de transistor MOS à canal N et la région (3) de transistor MOS à canal P ; former des trous de contact (22) dans la couche d'isolant intercouche de façon qu'un premier trou de contact expose une surface de la première électrode de grille et un autre trou de contact expose une surface de la deuxième électrode de grille ; et former une couche d'interconnexion (23) sur la couche d'isolant intercouche afin d'établir un contact avec les première et deuxième électrodes de grille via les trous de contact respectifs.

5. Procédé de production d'un dispositif à semiconducteur selon l'une quelconque des revendications 1 à 4, caractérisé en ce que ladite opération de formation de la première électrode de grille (8a) et de la première couche d'isolant de grille (7a) met en oeuvre une gravure anisotrope pour graver la première couche de conducteur (8) et la première couche d'isolant (7) à l'aide de gaz constitués d'agents de gravure mutuellement différents.

6. Procédé de production d'un dispositif à semiconducteur selon l'une quelconque des revendications 1 à 5, caractérisé en ce que l'opération de formation de la deuxième électrode de grille (15) et de la deuxième d'isolant de grille (17) met en oeuvre une gravure anisotrope pour graver la deuxième couche de conducteur (14) et la deuxième couche d'isolant (13) à l'aide de gaz constitués d'agents de gravure mutuellement différents.

7. Procédé de production d'un dispositif à semiconducteur selon l'une quelconque des revendications 1 à 6, caractérisé en ce que les première et deuxième couches de conducteur (8, 14) sont respectivement faites d'un matériau choisi dans le groupe suivant : silicium polycristallin, siliciure et polycide.

8. Procédé de production d'un dispositif à semiconducteur selon l'une quelconque des revendications 1 à 7, caractérisé en ce que la deuxième couche d'isolant (13) est faite d'un matériau choisi dans le groupe suivant : Si₃N₄ et SiON.

9. Procédé de production d'un dispositif à semiconducteur selon l'une quelconque des revendications 1 à 7, caractérisé en ce que la deuxième couche d'isolant (13) possède une structure multicouche choisie dans le groupe suivant :
SiO₂/Si₃N₄/SiO₂, SiON/SiO₂,
SiO₂ Si₃N₄, SiO₂/Si₃N₄, SiO₂/SiON et
Si₃N₄/SiO₂.

10. Dispositif à semiconducteur possédant un circuit CMOS qui comporte au moins un transistor MOS à canal P et un transistor MOS à canal N, ledit dispositif à semiconducteur comprenant un substrat semiconducteur (1), ainsi qu'une région (3) de transistor MOS à canal P et une région (4) de transistor MOS à canal N isolées par une région d'isolation (2) formée sur le substrat semi-conducteur,
ladite région de transistor MOS à canal P comprenant :
un puits de type N (5) formé sur le substrat semiconducteur (1) ; une deuxième couche d'isolant de grille (17) formée sur le substrat semiconducteur ;
des régions de diffusion de type P (18) formées dans le puits de type N de part et d'autre de la deuxième couche d'isolant de grille ; et une deuxième électrode de grille (15) formée sur la deuxième couche d'isolant de grille, ladite deuxième électrode de grille et lesdites régions de diffusion de type P formant respectivement la grille, la source et le drain du transistor MOS à canal P,
ladite région de transistor MOS à canal N comprenant :
un puits de type P (6) formé dans le substrat semiconducteur ; une première couche d'isolant de grille (7a) formée sur le substrat semiconducteur ;
des régions de diffusion de type N (20) formées dans le puits de type P de part et d'autre de la première couche d'isolant de grille ; et une première électrode de grille (8a) formée sur la première couche d'isolant de grille, ladite première électrode de grille ayant des surfaces de dessus et de côté, ladite première électrode de grille et lesdites régions de diffusion de type N formant respectivement la grille, la source et le drain du transistor MOS à canal N,
caractérisé en ce que ladite région de transistor MOS à canal N est dotée de : une couche isolante (9, 10, 12) qui couvre une partie des régions de diffusion de type N (20), les surfaces de côté de la première grille (7a, 8a) et au moins une partie de la surface de dessus de la première électrode de grille (8a), ladite couche isolante étant identique audit deuxième isolant de grille (17) ; et une couche de paroi latérale (16) qui est faite du même matériau que ladite deuxième électrode de grille (15), étant formée sur la couche isolante (9, 10, 12) de façon à réaliser un revêtement régulier autour du côté de la première électrode de grille et formant, en combinaison avec la couche isolante (9, 10, 12), la paroi latérale de la première grille (7a, 8a).

11. Dispositif à semiconducteur selon la revendication 10, caractérisé en ce que les première et deuxième électrodes de grille (8a, 15) sont respectivement faites d'un matériau choisi dans le groupe suivant : silicium polycristallin, siliciure et polycide.

12. Dispositif à semiconducteur selon la revendication 10 ou 11, caractérisé en ce que la couche isolante (10) est faite d'un matériau choisi dans le groupe suivant : Si₃N₄ et SiON.

13. Dispositif à semiconducteur selon la revendication 10 ou 11, caractérisé en ce que la couche isolante (10) possède une structure multicouche choisie dans le groupe suivant :
SiO₂/Si₃N₄/SiO₂,
SiON/SiO₂, SiO₂ Si₃N₄, SiO₂/Si₃N₄,
SiO₂/SiON et Si₃N₄/SiO₂.

14. Dispositif à semiconducteur selon l'une quelconque des revendications 10 à 13, qui comprend en outre un autre élément qui est formé sur le substrat semiconducteur (1), ladite couche isolante (10) se prolongeant pour se raccorder à l'élément et en former une partie.

15. Dispositif à semiconducteur selon une quelconque des revendications 10 à 14, caractérisé en ce que ladite couche isolante (9, 10, 12) est connectée audit deuxième isolant de grille (17) en une partie du dispositif à semiconducteur.
